# EUROPEAN PATENT APPLICATION

(11) **EP 1 701 394 A1**
(43) Date of publication of application: **13.09.2006**
(21) Application number: 06110390.9
(22) Date of filing: 24.02.2006
(51) Int. Cl.: H01L 51/50

(54) **Organic electroluminescent device and method of manufacturing the same**

(30) Priority: 05.03.2005 KR 2005018434
(71) Applicant: Samsung SDI Co., Ltd., Suwon-si Gyeonggi-do (KR)
(72) Inventor: Lee, Jun-Yeob,Legal&IP Team,Samsung SDI Co., Ltd.,, Gyeonggi-do (KR)
(74) Representative: Hengelhaupt, Jürgen

(57) **Abstract**

Provided is an organic EL device including a light-emitting layer between a first electrode and a second electrode, wherein the light-emitting layer includes a matrix polymer, two or more phosphorescent host materials, and at least one phosphorescent dopant. The organic EL device can increase an energy transfer efficiency by use of a mixture of phosphorescent host materials, and thus have better efficiency and lifetime characteristics, and can be produced by a solution process such as spin-coating.

## Description

### BACKGROUND OF THE INVENTION

### Field of the Invention

The present embodiments relate to an organic electroluminescent device, and more particularly, to an organic electroluminescent device which can be manufactured by a solution process and includes two or more phosphorescent host materials.

### Description of the Related Art

A light-emitting material for an organic electroluminescent (EL) device is divided into a fluorescent material using a singlet exciton and a phosphorescent material using a triplet exciton according to an emission mechanism.

Generally, a phosphorescent material has a heavy atom-containing organometallic compound structure. Phosphorescent material produces phosphorescent emissions since the normally forbidden transition of a triplet excition state is allowed. Since a phosphorescent material can use triplet excitons with the probability of formation of 75%, it can have much higher emission efficiency than a fluorescent material using singlet excitons with the probability of formation of 25%.

A light-emitting layer using a phosphorescent material is composed of a host material and a dopant material producing emission through energy transfer from the host material. As the dopant material, there have been reported many iridium-based dopant materials. In particular, as blue light-emitting materials, iridium compounds carrying (4,6-F₂ppy)₂Irpic or fluorinated ppy ligand structures were developed. As host materials for these materials, CBP (4,4'-N,N'-dicarbazole-biphenyl) molecules have been widely used. It has been reported that the energy band gaps of the triplet states of the CBP molecules are sufficient to allow for energy transfer to green light-emitting or red light-emitting materials but are smaller than the energy band gaps of blue-emitting materials, thereby leading to very inefficient endothermic energy transfer instead of exothermic energy transfer. For this reason, the CBP molecules as host materials provide insufficient energy transfer to blue light- emitting dopants, thereby leading to problems of low blue light-emission efficiency and short device lifetime.

Recently, there has been reported a method of forming a light-emitting layer using a phosphorescent host material with a greater triplet energy bandgap than CBP and a matrix polymer enabling a solution process.

However, currently available organic EL devices using phosphorescent host materials still have unsatisfactory device efficiency and lifetime characteristics.

Korean Patent Application No. 2004-98372 and No. 2004-89652, filed by the present applicant, discloses a method of manufacturing an organic EL device with better efficiency and lifetime in which a light-emitting layer is formed between a first electrode and a second electrode using two or more host materials, the disclosures of which are incorporated herein in its entirety by reference.

In the above patent documents, the light-emitting layer is formed by vacuum deposition of the two or more host materials. However, a vacuum deposition for forming a light-emitting layer has disadvantages over a solution process in terms of stable crystallization, simplicity of the process, large-scale fabrication, etc. Thus, it is advantageous to develop an organic EL device that has better efficiency and lifetime characteristics and can be manufactured by a solution process.

### SUMMARY OF THE INVENTION

The present invention provides an organic electroluminescent device which enables a solution process such as spin-coating, and has better efficiency and lifetime characteristics by using two or more phosphorescent host materials.

The present invention also provides a method of manufacturing an organic electroluminescent device using a solution process.

According to the present invention, there is provided an organic electroluminescent device comprising a light-emitting layer between a first electrode and a second electrode, wherein the light-emitting layer comprises a matrix polymer, two or more phosphorescent host materials, and at least one phosphorescent dopant.
Preferably the matrix polymer is at least one selected from polyphenylenevinylene (PPV), polyvinylcarbazole (PVK), polyfluorene, and derivatives thereof Preferably the content of the matrix polymer ranges from 50 to 200 parts by weight, based on the total weight 100 parts by weight of the two or more phosphorescent host materials. Preferably the two or more phosphorescent host materials are composed of a first host material and a second host material, and the first host material and the second host material are different in at least one of a HOMO (highest occupied molecule orbital) level and a LUMO (lowest unoccupied molecule orbital) level. Preferably each of the first host material and the second host material has a triplet energy level of 2.3 to 3.5 eV. Preferably at least one of the two or more phosphorescent host materials is a carbazole compound. Preferably the carbazole compound is selected from the group consisting of 1,3,5-triscarbazolylbenzene, 4,4'-biscarbazolylbiphenyl(CBP), m-biscarbazolylphenyl, 4,4'-biscarbazolyl-2,2'-dimethylbiphenyl (dmCBP), 4,4',4"-tris(N-carbazolyl)triphenylamine, 1,3,5-tris(2-carbazolylphenyl)benzene, 1,3,5-tris(2-carbazolyl-5-methoxyphenyl)benzene, and bis(4-carbazolylphenyl)silane. Preferably at least one of the two or more phosphorescent host materials is selected from an organometallic complex, a spirofluorene compound, an oxadiazole compound, a phenanthroline compound, a triazine compound, and a triazole compound. Preferably the organometallic complex is bis(8-hydroxyquinolato)biphenoxy aluminum (III), bis(8-hydroxyquinolato)phenoxy aluminum (III), bis(2-methyl-8-hydroxyquinolato)biphenoxy aluminum (III), bis(2-methyl-8-hydroxyquinolato)naphthoxy aluminum (III), bis(2-methyl-8-hydroxyquinolato)phenoxy aluminum (III), bis(2-(2-hydroxyphenyl)quinolato) zinc (II), or bis(2-methyl-8-quinolinolato)(para-phenyl-phenolato) aluminum (III). Preferably the spirofluorene compound is 2,5-dispirobifluorene-1,3,4-oxadiazole, the oxadiazole compound is (4-biphenylyl)-5-(4-tert-butylphenyl)-1,3,4-oxadiazole, and the phenanthroline compound is 2,9-dimethyl-4,7-diphenyl-9,10-phenanthroline. Preferably the triazine compound is 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-phenyl-1-naphthylamino)-1,3,5-triazine, or 2,4,6-trisbiphenyl-1,3,5-triazine, and the triazole compound is 3-phenyl-4-(1-naphthyl)-5-phenyl-1,2,4-triazole. Preferably the mixed weight ratio of the first host material to the second host material ranges from 9:1 to 1:9. Preferably the phosphorescent dopant is at least one selected from the group consisting of bisthienylpyridine acetylacetonate Iridium, bis(benzothienylpyridine)acetylacetonate Iridium, bis(2-phenylbenzothiazole)acetylacetonate Iridium, bis(1-phenylisoquinoline) Iridium acetylacetonate, tris(1-phenylisoquinoline) Iridium, and tris(2-biphenylpyridine) Iridium. Preferably the content of the phosphorescent dopant ranges from 1 to 45 parts by weight, based on the total weight 100 parts by weight of the two or more phosphorescent host materials. Preferably the matrix polymer is polyvinylcarbazole (PVK), the phosphorescent host materials are CBP and Balq, and the phosphorescent dopant is bis(1-phenylisoquinoline) iridium (III) acetylacetonate [pq2Ir(acac)]. Preferably the organic EL device is further comprising at least one selected from a hole injection layer and a hole transport layer between the first electrode and the light-emitting layer. Preferably the organic EL device is further comprising at least one selected from a hole blocking layer, an electron transport layer, and an electron injection layer between the light-emitting layer and the second electrode.

According to another aspect of the present invention, there is provided a method of manufacturing an organic EL device including a light-emitting layer located between a first electrode and a second electrode, the method comprising: mixing a matrix polymer, two or more host materials, and at least one phosphorescent dopant material to prepare a composition for forming the light-emitting layer; and coating the composition onto the first electrode.
Preferably a solvent used for preparing the composition is at least one selected from the group consisting of benzene, toluene, and chlorobenzene. Preferably the step of coating the composition onto the first electrode is performed by one selected from the group consisting of spin-coating, inkjet printing, dip-coating, doctor-blading, and thermal transfer.

### BRIEF DESCRIPTION OF THE DRAWINGS

The above and other features and advantages of the present embodiments will become more apparent by describing in detail exemplary embodiments thereof with reference to the attached drawings in which:

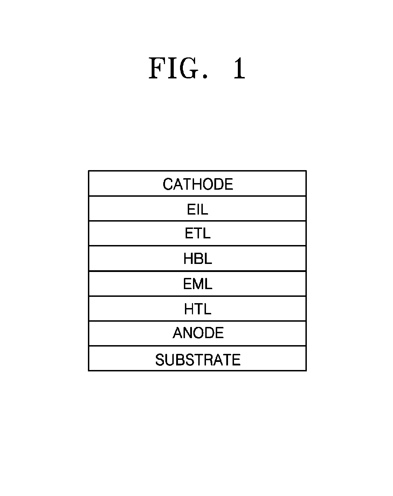

FIG. 1 illustrates a sectional view of an organic EL device according to an embodiment.

### DETAILED DESCRIPTION OF THE INVENTION

Hereinafter, the present embodiments will be described in more detail.

In the present embodiments, an organic EL device has better efficiency and lifetime characteristics by forming a light-emitting layer between a first electrode and a second electrode using a matrix polymer, two or more phosphorescent host materials, and at least one phosphorescent dopant. That is, the efficiency and lifetime of an organic EL device can be enhanced by increasing recombination probability in the light-emitting layer by forming a light-emitting layer using a solution process and two or more host materials.

The two or more phosphorescent host materials of the organic EL device of the present embodiments may be composed of a first host material and a second host material. The first host material and the second host material may be the same or different in at least one of a highest occupied molecular orbital (HOMO) level and a lowest unoccupied molecular orbital (LUMO) level.

When the energy level of the first host material is different from that of the second host material, holes and electrons are injected into and move in a light-emitting layer along a more stable energy level, thereby increasing recombination probability in the light-emitting layer and preventing the loss of charges from the light-emitting layer. On the other hand, when the energy level of the first host material is the same as that of the second host material, the above effects cannot be obtained. Thus, to move charges along a stable energy level, it is required that the two host materials are different in at least one of a HOMO level and a LUMO level.

The triplet energy level of each of the first and second host materials may range from about 2.3 to about 3.5 eV.

The two or more phosphorescent host materials of the present embodiments may be two or more selected from hole-transport host materials with hole transport property and electron-transport host materials with electron transport property. That is, the two or more phosphorescent host materials may be two or more hole-transport host materials, at least one hole-transport host material and at least one electron-transport host material, or two or more electron-transport host materials.

The hole-transport host material may be a carbazole compound.

Such a carbazole compound may be selected from the group consisting of 1,3,5-triscarbazolylbenzene, 4,4'-biscarbazolylbiphenyl (CBP), polyvinylcarbazole, m-biscarbazolylphenyl, 4,4'-biscarbazolyl-2,2'-dimethylbiphenyl (dmCBP), 4,4',4"-tris(N-carbazolyl)triphenylamine, 1,3,5-tris(2-carbazolylphenyl)benzene, 1,3,5-tris(2-carbazolyl-5-methoxyphenyl)benzene, and bis(4-carbazolylphenyl)silane, but is not limited to the above-illustrated examples.

The electron-transport host material may be at least one selected from an organometallic complex including a metal and an organic ligand, a spirofluorene compound, an oxadiazole compound, a phenanthroline compound, a triazine compound, and a triazole compound.

The organometallic complex may be selected from the group consisting of bis(8-hydroxyquinolato)biphenoxy metal ion, bis(8-hydroxyquinolato)phenoxy metal ion, bis(2-methyl-8-hydroxyquinolato)biphenoxy metal ion, bis(2-methyl-8-hydroxyquinolato)naphthoxy metal ion, bis(2-methyl-8-hydroxyquinolato)phenoxy metal ion, bis(2-methyl-8-quinolinolato)(para-phenyl-phenolato) metal ion, and bis(2-(2-hydroxyphenyl)quinolato) metal ion, but is not limited to the above-illustrated examples. Here, the metal ion may be aluminum (A1³⁺), zinc (Zn²⁺), beryllium (Be²⁺), or gallium (Ga³⁺).

Particularly, the electron-transport host material may be bis(8-hydroxyquinolato)biphenoxy aluminum (III), bis(8-hydroxyquinolato)phenoxy aluminum, bis(2-methyl-8-hydroxyquinolato)biphenoxy aluminum (III), bis(2-methyl-8-hydroxyquinolato)phenoxy aluminum (III), bis(2-methyl-8-quinolinolato)(para-phenyl-phenolato) aluminum (III) (BA1q), or bis(2-(2-hydroxyphenyl)quinolato) zinc (II).

The spirofluorene compound has two spirofluorenes linked via a ring structure such as triazole, oxadiazole, naphthalene, anthracene, or phenyl. An O, S, Se, N-R, P-R group, etc., may be located at the position 9 of each spirofluorene, or two spirofluorenes may be directly connected by N-R or P-R groups. Here, each R is H or a substituent selected from the group consisting of an alkyl group of 1-20 carbon atoms, an aryl group of 5-20 carbon atoms with an alkyl moiety of 1-20 carbon atoms, a heteroaryl group of 2-20 carbon atoms, and an aryl group of 6-20 carbon atoms with an alkoxy moiety of 1-20 carbon atoms. The spirofluorene compound may be 2,5-dispirobifluorene-1,3,4-oxadiazole.

The oxadiazole compound may be (4-biphenylyl)-5-(4-tert-butylphenyl)-1,3,4-oxadiazole, the phenanthroline compound may be 2,9-dimethyl-4,7-diphenyl-9,10-phenanthroline (BCP), the triazine compound may be 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-phenyl-1-naphthylamino)-1,3,5-triazine, or 2,4,6-trisbiphenyl-1,3,5-triazine, and the triazole compound may be 3-phenyl-4-(1-naphthyl)-5-phenyl-1,2,4-triazole. However, the present embodiments are not limited to the above-illustrated examples.

The mixed weight ratio of the first host material and the second host material may range from about 1:9 to about 9:1, preferably from about 1:3 to about 3:1, and more preferably about 3:1.

According to the present embodiments, as described above, a mixture of two or more host materials is used instead of a single host material, thereby ensuring better efficiency and lifetime characteristics of the EL. Furthermore, a light-emitting layer including such two or more host materials can be formed by a solution process, such as, for example, spin-coating, dip-coating, doctor-blading, inkjet printing, or thermal transfer. To perform such a solution process, it is necessary to use a matrix polymer, for example, polyethyleneglycol, polyvinylpyrrolidone, polyvinylalcohol, starch, xanthan, or cellulose, which has good solubility in an organic solvent such as benzene, toluene, and chlorobenzene.

The matrix polymer of the present embodiments may be a common material with broad energy level bandgap, but the present embodiments are not limited thereto. At least one selected from polyphenylenevinylene (PPV), polyvinylcarbazole (PVK), polyfluorene, and derivatives thereof are preferable.

The content of the matrix polymer may range from about 50 to about 200 parts by weight based on 100 parts by weight of the two or more phosphorescent host materials.

The phosphorescent dopant used for forming a light-emitting layer according to the present embodiments may be represented by Ir(L)3 or Ir(L)2L' where each of L and L' may be selected from the following structural formulae:

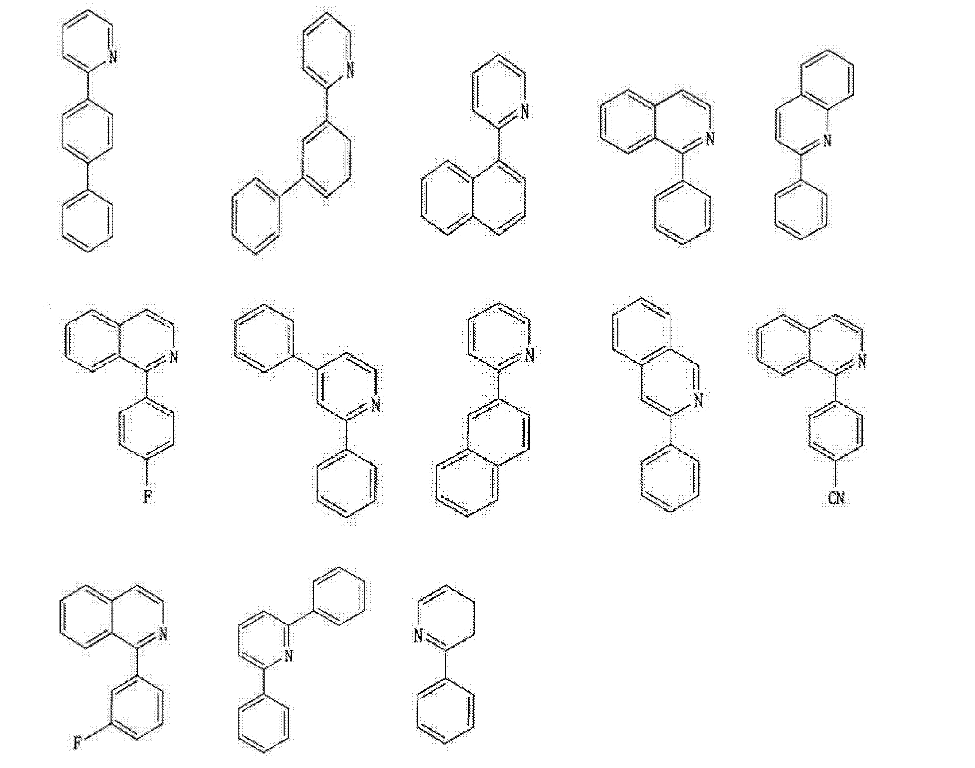

The phosphorescent dopant may be at least one selected from bisthienylpyridine acetylacetonate Iridium, bis(benzothienylpyridine)acetylacetonate Iridium, bis(2-phenylbenzothiazole)acetylacetonate Iridium, bis(1-phenylisoquinoline) Iridium acetylacetonate, tris(phenylpyridine) Iridium, tris(2-biphenylpyridine) Iridium, tris(3-biphenylpyridine) Iridium, and tris(4-biphenylpyridine) Iridium, but is not limited to the above-illustrated examples.

The content of the phosphorescent dopant used herein may range from about 1 to about 45 parts by weight based on 100 parts by weight of the two or more phosphorescent host materials.

The two or more phosphorescent host materials of the present embodiments may be a carbazole compound with hole transport property and at least one compound with electron transport property selected from an oxadiazole compound, a phenanthroline compound, a triazine compound, and a triazole compound. In this case, there is no need to form a hole-blocking layer (HBL), which enables the fabrication of an organic EL device with simplified device structure and better emission efficiency and lifetime characteristics.

The matrix polymer may be polyvinylcarbazole (PVK), for example, the first and second host materials may be CBP and BAlq, respectively, and the phosphorescent dopant may be bis(1-phenylisoquinoline) iridium acetylacetonate.

The organic EL device of the present embodiments may further include at least one of a hole injection layer and a hole transport layer between the first electrode and the light-emitting layer. At least one selected from a hole blocking layer, an electron transport layer, and an electron injection layer may be further interposed between the light-emitting layer and the second electrode.

A method of manufacturing an organic EL device according to an embodiment will now be described with reference to FIG. 1.

First, an anode material is coated on a substrate to form an anode used as a first electrode. The substrate may be a substrate commonly used for organic EL devices. Preferably, the substrate is a glass substrate or a transparent plastic substrate which is excellent in transparency, surface smoothness, handling property, and water resistance. The anode material may be a material which is excellent in transparency and conductivity, for example, indium tin oxide (ITO), indium zinc oxide (IZO), tin oxide (SnO₂) or zinc oxide (ZnO).

A hole injection layer (HIL) is optionally formed on the anode by thermal evaporation of a hole injection layer material on the anode or by spin-coating, dip-coating, doctor-blading, inkjet printing, thermal transfer, or organic vapor phase deposition (OVPD) of a hole injection layer material-containing solution. Here, the thickness of the hole injection layer may range from about 50 Å to about 1,500 Å.

The hole injection layer material is not particularly restricted. Copper phthalocyanine (CuPc), Starburst amines such as TCTA and m-MTDATA (represented by the following structural formulae) or IDE406 (Idemitsu Corporation) may be used as the hole injection layer material:

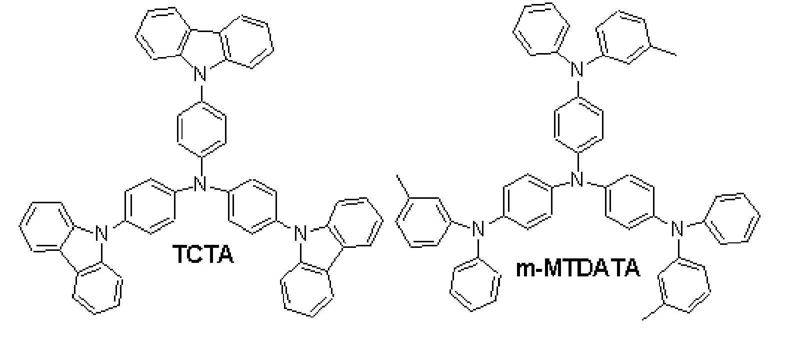

A hole transport layer (HTL) is optionally formed on the hole injection layer by coating a hole transport layer material on the hole injection layer using any one of the above-exemplified methods. The hole transport layer material is not particularly restricted. One of IDE320 (Idemitsu Corporation), N,N'-bis(3-methylphenyl)-N,N'-diphenyl-[1,1-biphenyl]-4,4'diamine (TPD) and N,N'-di(naphthalene-1-yl)-N,N'-diphenyl benzidine (NPD) represented by the following structural formulae may be used as the hole transport layer material. Here, the thickness of the hole transport layer may range from about 50 Å to about 1,500Å:

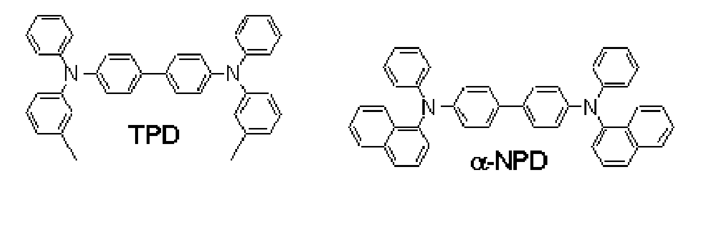

A light-emitting layer (EML) is then formed on the hole transport layer using a matrix polymer, two or more phosphorescent host materials, and a phosphorescent dopant.

The present embodiments also provide a method of manufacturing an organic EL device including a light-emitting layer between a first electrode and a second electrode, which includes mixing a matrix polymer, two or more phosphorescent host materials, and at least one phosphorescent dopant material to prepare a composition for the light-emitting layer and coating the composition onto the first electrode to form the light-emitting layer.

A solvent used for preparing the composition for the light-emitting layer may be at least one selected from the group consisting of benzene, toluene, and chlorobenzene. The composition for the light-emitting layer may be coated on the first electrode by one selected from the group consisting of spin-coating, inkjet printing, dip-coating, doctor-blading, or thermal transfer to form the light-emitting layer.

The thickness of the light-emitting layer may range from about 100 Å to about 800 Å, and more preferably from about 300 Å to about 400 Å

A hole blocking layer (HBL) is optionally formed on the light-emitting layer by vacuum deposition or spin-coating of a hole blocking layer material. The hole blocking layer material is not particularly restricted provided that it has electron transport capability and greater ionization potential than a light-emitting compound. Balq, BCP, TPBI (represented by the following structural formulae), etc. may be used. The thickness of the hole blocking layer may range from about 30 Å to about 500 Å.

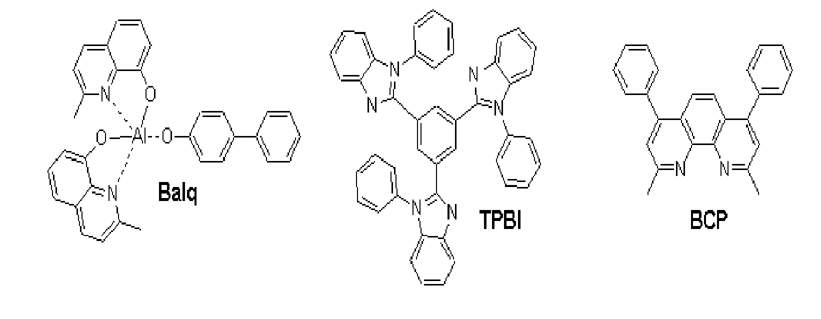

An electron transport layer (ETL) is optionally formed on the hole blocking layer using an electron transport layer material. The electron transport layer material is not particularly restricted but may be Alq3. The thickness of the electron transport layer may range from about 50 Å to about 600 Å.

An electron injection layer (EIL) may be optionally formed on the electron transport layer. An electron injection layer material may be LiF, NaCl, CsF, Li₂O, BaO, Liq (represented by the following structural formula), etc. The thickness of the electron injection layer may range from about 1 Å to about 100 Å.

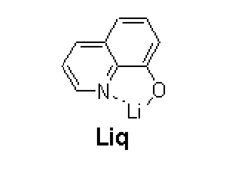

Finally, a cathode used as a second electrode is formed on the electron injection layer by vacuum thermal deposition of a cathode metal to complete an organic EL device.

The cathode metal may be lithium (Li), magnesium (Mg), aluminum (Al), aluminum-lithium (Al-Li), calcium (Ca), magnesium-indium (Mg-In), magnesium-silver (Mg-Ag), or the like.

The organic EL device of the present embodiments may include, as needed, one or two interlayers among the anode, the hole injection layer, the hole transport layer, the light-emitting layer, the electron transport layer, the electron injection layer, and the cathode.

Hereinafter, the present embodiments will be described more specifically by examples. However, the following examples are provided only for illustrations and thus the present embodiments are not limited to or by them.

### EXAMPLES

The contents of components used in the following Examples are expressed by "part(s) by weight" based on 100 parts by weight of two or more phosphorescent host materials.

### Example 1

A Coming 15Ω /cm² (1,200A) ITO glass substrate was cut into pieces of 50 mm x 50 mm x 0.7 mm in size, followed by ultrasonic cleaning in isopropyl alcohol and deionized water (5 minutes for each) and then UV/ozone cleaning (30 minutes), to be used as an anode.

A hole transport layer was formed to a thickness of 600 Å on the substrate by vacuum deposition of N,N'-bis(3-methylphenyl)- N,N'-diphenyl-[I,I-biphenyl]-4,4'-diamine (TPD).

A light-emitting layer was formed to a thickness of about 400 Å on the hole transport layer by spin-coating of a solution obtained by dissolving 100 parts by weight of polyvinylcarbazole (PVK) used as a matrix polymer, 90 parts by weight of 4,4'-biscarbazolylbiphenyl (CBP) and 10 parts by weight of BAlq used as phosphorescent host materials, and 10 parts by weight of bis(1-phenylisoquinoline) iridium acetylacetonate [pq2Ir(acac)] used as a phosphorescent dopant in toluene.

An electron transport layer was formed to a thickness of about 300Å on the light-emitting layer by spin-coating of Alq3 used as an electron transport layer material.

An Lif/A1 electrode was formed on the electron transport layer by sequential deposition of LiF (10Å, electron injection layer) and A1 (1,000Å, cathode) to complete an organic EL device.

### Example 2

An organic EL device was manufactured in the same manner as in Example 1 except that 75 parts by weight of CBP and 25 parts by weight of BAlq were used for formation of a light-emitting layer.

### Example 3

An organic EL device was manufactured in the same manner as in Example 1 except that 50 parts by weight of CBP and 50 parts by weight of BAlq were used for formation of a light-emitting layer.

### Example 4

An organic EL device was manufactured in the same manner as in Example 1 except that 25 parts by weight of CBP and 75 parts by weight of BAlq were used for formation of a light-emitting layer.

### Example 5

An organic EL device was manufactured in the same manner as in Example 1 except that 10 parts by weight of CBP and 90 parts by weight of BAlq were used for formation of a light-emitting layer.

### Comparative Example 1

A Coming 15Ω /cm² (1,200Å) ITO glass substrate was cut into pieces of 50 mm x 50 mm x 0.7 mm in size, followed by ultrasonic cleaning in isopropyl alcohol and deionized water (5 minutes for each) and then UV/ozone cleaning (30 minutes), to be used as an anode.

A hole transport layer was formed to a thickness of 600 Å on the substrate by vacuum deposition of TPD. A light-emitting layer was then formed to a thickness of 400 Å on the hole transport layer by spin-coating of a solution obtained by dissolving 100 parts by weight of PVK used as a matrix polymer, 100 parts by weight of CBP used as a phosphorescent host material, and 10 parts by weight of pq2Ir(acac) in toluene.

An electron transport layer was formed to a thickness of about 300Å on the light-emitting layer by spin-coating of Alq3 used as an electron transport material.

An Lif/A1 electrode was formed on the electron transport layer by sequential vacuum deposition of LiF (10 Å, electron injection layer) and Al (1,000 Å, cathode) to complete an organic EL device as shown in FIG. 1.

### Comparative Example 2

An organic EL device was manufactured in the same manner as in Comparative Example 1 except that a light-emitting layer was formed to a thickness of 400 Å using 100 parts by weight BAlq as a phosphorescent host material instead of 100 parts by weight of CBP.

Emission efficiency and lifetime characteristics for the organic EL devices manufactured in Examples 1-5 and Comparative Examples 1-2 were evaluated.

The emission efficiency and the lifetime characteristics were evaluated using a spectrometer and a photodiode, respectively, and the results are presented in Table 1 below.

The organic EL device of Example 2 exhibited better emission efficiency of 10cd/A, as compared to the emission efficiencies (about 8cd/A and 6cd/A, respectively) of the organic EL devices of Comparative Examples 1 and 2.

The lifetime characteristics were represented by the time required for reaching 50% of initial brightness. At brightness of 500cd/m², the lifetime of the organic EL device of Example 2 was 300 hours, whereas the lifetimes of the organic EL devices of Comparative Examples 1-2 were 100 hours and 90 hours, respectively. This shows that the organic EL devices of Examples 1-5 exhibit better lifetime characteristics relative to those of Comparative Examples 1-2.

**Table 1**

| Example | Ratio of CBP:BAlq | Efficiency (cd/A) | Lifetime (hrs) |
|---|---|---|---|
| Example 1 | 90:10 | 9 | 180 |
| Example 2 | 75:25 | 10 | 300 |
| Example 3 | 50:50 | 10 | 250 |
| Example 4 | 25:75 | 9 | 200 |
| Example 5 | 10:90 | 9 | 150 |
| Comparative Example 1 | 100:0 | 8 | 100 |
| Comparative Example 2 | 0:100 | 6 | 90 |

A light-emitting layer of an organic EL device of the present embodiments includes a matrix polymer, two or more phosphorescent host materials, and a phosphorescent dopant, and has a structure that can be produced by a solution process such as spin-coating, thereby enhancing device efficiency and lifetime characteristics.

While the present embodiments haves been particularly shown and described with reference to exemplary embodiments thereof, it will be understood by those of ordinary skill in the art that various changes in form and details may be made therein without departing from the scope of the present embodiments as defined by the following claims.

## Claims

1. An organic electroluminescent device comprising a light-emitting layer between a first electrode and a second electrode,
wherein the light-emitting layer comprises a matrix polymer, two or more phosphorescent host materials, and at least one phosphorescent dopant.

2. The organic electroluminescent device of claim 1, wherein the matrix polymer is at least one selected from polyphenylenevinylene (PPV), polyvinylcarbazole (PVK), polyfluorene, and derivatives thereof

3. The organic electroluminescent device according to at least one of the claims 1 or 2, wherein the content of the matrix polymer ranges from 50 to 200 parts by weight, based on the total weight 100 parts by weight of the two or more phosphorescent host materials.

4. The organic electroluminescent device according to at least one of the preceding claims, wherein the two or more phosphorescent host materials are composed of a first host material and a second host material, and the first host material and the second host material are different in at least one of a HOMO level and a LUMO level.

5. The organic electroluminescent device according to claim 4, wherein each of the first host material and the second host material has a triplet energy level of 2.3 to 3.5 eV and/or wherein at least one of the two or more phosphorescent host materials is a carbazole compound and/or wherein at least one of the two or more phosphorescent host materials is selected from an organometallic complex, a spirofluorene compound, an oxadiazole compound, a phenanthroline compound, a triazine compound, and a triazole compound.

6. The organic electroluminescent device according to claim 5, wherein the carbazole compound is selected from the group consisting of 1,3,5-triscarbazolylbenzene, 4,4'-biscarbazolylbiphenyl(CBP), m-biscarbazolylphenyl, 4,4'-biscarbazolyl-2,2'-dimethylbiphenyl (dmCBP), 4,4',4"-tris(N-carbazolyl)triphenylamine, 1,3,5-tris(2-carbazolylphenyl)benzene, 1,3,5-tris(2-carbazolyl-5-methoxyphenyl)benzene, and bis(4-carbazolylphenyl)silane.

7. The organic electroluminescent device according to claim 6, wherein the organometallic complex is bis(8-hydroxyquinolato)biphenoxy aluminum (III), bis(8-hydroxyquinolato)phenoxy aluminum (III), bis(2-methyl-8-hydroxyquinolato)biphenoxy aluminum (III), bis(2-methyl-8-hydroxyquinolato)naphthoxy aluminum (III), bis(2-methyl-8-hydroxyquinolato)phenoxy aluminum (III), bis(2-(2-hydroxyphenyl)quinolato) zinc (II), or bis(2-methyl-8-quinolinolato)(para-phenyl-phenolato) aluminum (III).

8. The organic electroluminescent device according to claim 5, wherein the spirofluorene compound is 2,5-dispirobifluorene-1,3,4-oxadiazole, the oxadiazole compound is (4-biphenylyl)-5-(4-tert-butylphenyl)-1,3,4-oxadiazole, and the phenanthroline compound is 2,9-dimethyl-4,7-diphenyl-9,10-phenanthroline and/or wherein the triazine compound is 2,4,6-tris(diarylamino)-1,3,5-triazine, 2,4,6-tris(diphenylamino)-1,3,5-triazine, 2,4,6-tricarbazolo-1,3,5-triazine, 2,4,6-tris(N-phenyl-2-naphthylamino)-1,3,5-triazine, 2,4,6-tris(N-phenyl-1-naphthylamino)-1,3,5-triazine, or 2,4,6-trisbiphenyl-1,3,5-triazine, and the triazole compound is 3-phenyl-4-(1-naphthyl)-5-phenyl-1,2,4-triazole.

9. The organic electroluminescent device according to claim 4, wherein the mixed weight ratio of the first host material to the second host material ranges from 9:1 to 1:9.

10. The organic electroluminescent device according to at least one of the preceding claims, wherein the phosphorescent dopant is at least one selected from the group consisting of bisthienylpyridine acetylacetonate Iridium, bis(benzothienylpyridine)acetylacetonate Iridium, bis(2-phenylbenzothiazole)acetylacetonate Iridium, bis(1-phenylisoquinoline) Iridium acetylacetonate, tris(1-phenylisoquinoline) Iridium, and tris(2-biphenylpyridine) Iridium and/or wherein the content of the phosphorescent dopant ranges from 1 to 45 parts by weight, based on the total weight 100 parts by weight of the two or more phosphorescent host materials.

11. The organic electroluminescent device according to at least one of the preceding claims, wherein the matrix polymer is polyvinylcarbazole (PVK), the phosphorescent host materials are CBP and Balq, and the phosphorescent dopant is bis(1-phenylisoquinoline) iridium (III) acetylacetonate [pq2Ir(acac)] and/or wherein the organic electroluminescent device further comprises at least one selected from a hole injection layer and a hole transport layer between the first electrode and the light-emitting layer and/or wherein the organic electroluminescent device further comprises at least one selected from a hole blocking layer, an electron transport layer, and an electron injection layer between the light-emitting layer and the second electrode.

12. A method of manufacturing an organic electroluminescent device comprising a light-emitting layer between a first electrode and a second electrode, the method comprising:
mixing a matrix polymer, two or more host materials, and at least one phosphorescent dopant material to prepare a composition for forming the light-emitting layer; and
coating the composition onto the first electrode.

13. The method of claim 12, wherein a solvent used for preparing the composition is at least one selected from the group consisting of benzene, toluene, and chlorobenzene.

14. The method according to at least one of the claims 12 or 13, wherein coating the composition onto the first electrode is performed by one selected from the group consisting of spin-coating, inkjet printing, dip-coating, doctor-blading, and thermal transfer.
